# EUROPEAN PATENT APPLICATION

(11) **EP 2 781 889 A1**
(43) Date of publication of application: **24.09.2014**
(21) Application number: 14160169.0
(22) Date of filing: 17.03.2014
(51) Int. Cl.: G01D 5/241, G01D 11/30, H04H 60/04

(54) **Electrostatic sensor and slide operation apparatus**

(30) Priority: 18.03.2013 JP 2013054841
(71) Applicant: YAMAHA CORPORATION, Hamamatsu-shi Shizuoka 430-8650 (JP)
(72) Inventor: Niwa, Haruo, Hamamatsu-shi Shizuoka 430-8650 (JP)
(74) Representative: Ettmayr, Andreas

(57) **Abstract**

An electrostatic sensor includes a fixed electrode (30), a movable electrode (26), an analyzing unit (103), a sliding member (261), and a crimping member (25, 11). The fixed electrode (30) is arranged along a predetermined direction. The movable electrode (26) faces the fixed electrode (3 0). The analyzing unit (103) is configured to detect a position of the movable electrode (26) based on capacitance between the movable electrode (26) and the fixed electrode (30). The sliding member (261) is disposed between the fixed electrode (30) and the movable electrode (26). The crimping member (25, 11) crimps the fixed electrode (30) and the movable electrode (26) together by a magnetic force.

## Description

### {Technical Field}

The invention relates to an electrostatic sensor that detects a position using a change in electric potential and to a slide operation apparatus that includes the electrostatic sensor.

### {Background Art}

An electronic musical instrument, an acoustic mixer, or similar instrument employs a slide operation apparatus that includes faders. In the fader, a control such as a knob disposed in an upper portion of a main body in a box shape is slid to set parameters such as a sound volume, a sound quality, and an effect corresponding to a slide position of the control.

On the fader, a position detecting device for detecting the slide position of the control is mounted. For example, PTL 1 discloses a configuration where a control is pressed against the top surface of a resistive element and the resistance value that changes corresponding to the position change of the operator is detected so as to detect the slide position.

However, in the method that detects the position by change of the resistance value, the resistance value may be changed by contamination, abrasion, or similar defects of a contacting portion between the operator and the resistive element.

Therefore, for example, an electrostatic sensor is known as a contactless position detecting sensor with high reliability and durability (see PTL 2).

### {Citation List}

### {Patent Literature}

{PTL1} JP 2002-124405 A
{PTL 2} JP 2011-47679 A

### {Summary of Invention}

### {Technical Problem}

However, in the electrostatic sensor, a change in interelectrode distance changes the electric potential due to electrostatic induction. Accordingly, it is necessary to keep a constant interelectrode distance with high accuracy.

Therefore, an object of the invention is to provide an electrostatic sensor that keeps a constant interelectrode distance without using a precision mechanical component or a component in a complex shape for ensuring position accuracy.

### {Solution to Problem}

An electrostatic sensor of the invention includes a fixed electrode, a movable electrode, and an analyzing unit. The fixed electrode is arranged along a predetermined direction. The movable electrode faces the fixed electrode. The analyzing unit is configured to detect a position of the movable electrode based on capacitance between the movable electrode and the fixed electrode.

Additionally, the electrostatic sensor includes a sliding member and a crimping member. The sliding member is disposed between the fixed electrode and the movable electrode. The crimping member crimps the fixed electrode and the movable electrode together by magnetic force.

Accordingly, the electrostatic sensor of the invention crimps the electrodes with each other by magnetic force. This allows applying a uniform pressure in a wide area compared with a method for crimping using a leaf spring or similar configuration, thus allowing the slide of the movable electrode while ensuring a constant interelectrode distance without using a precision mechanical component or a component in a complex shape. Additionally, adjusting the intensity of the magnetic field easily controls the pressure in the crimping. This ensures a constant interelectrode distance while enabling to slide the movable electrode with a small operating force.

The crimping member preferably includes a housing made of magnetic material and a magnet arranged inside the housing. It is preferable that the housing and the magnet form are structured such that the housing and the magnet sandwich the fixed electrode and the movable electrode between them. Accordingly, when the magnet is arranged inside the housing, the magnetic flux does not leak out of the housing. This reduces the influence on other components.

The sliding member is preferably made of a material with a low friction coefficient and high durability, for example, high-molecular polyethylene.

The electrostatic sensor of the invention is used together with a moving body that moves in a predetermined direction, so as to function as a slide operation apparatus. In this case, it is preferable that the moving body includes a contact portion in contact with a part of the crimping member. The contact portion transmits a moving force transmitted to the moving body to the crimping member. It is preferable that the movable electrode moves in the predetermined direction in association with movement of the moving body. That is, all the components are not preferably integrated. While the fixed electrode and the movable electrode are crimped together, the moving body itself preferably transmits a moving force to the movable electrode as a separate component. This structure ensures a margin such that the moving body itself can move in directions other than the predetermined direction to some extent. This eliminates the need for excessively high dimension accuracy of the components, thus facilitating the production.

### {Advantageous Effects of Invention}

The invention enables to keep a constant interelectrode distance without using a precision mechanical component or a component in a complex shape for ensuring position accuracy.

### {Brief Description of Drawings}

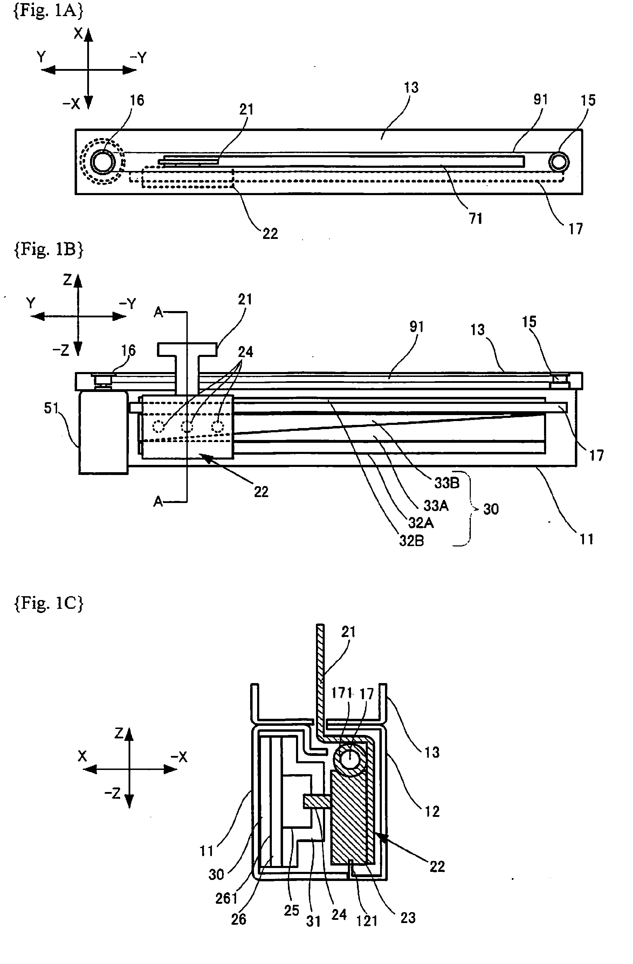

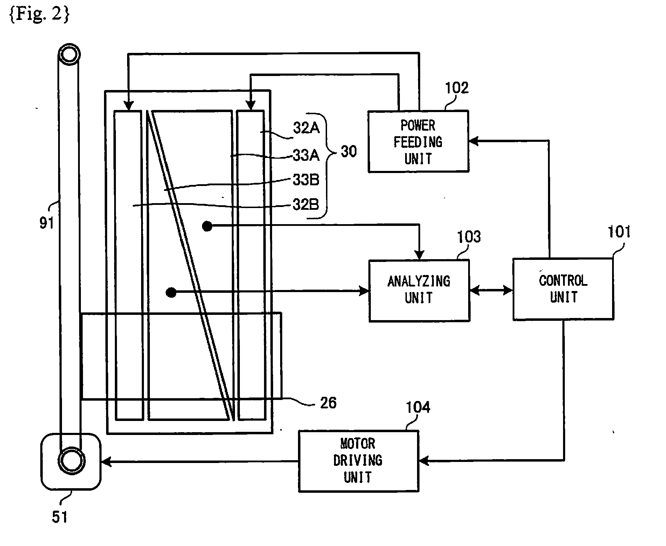

{Fig. 1A} Fig. 1A is a top view of a slide operation apparatus.
{Fig. 1B} Fig. 1B is a side view of the slide operation apparatus.
{Fig. 1C} Fig. 1C is a cross-sectional view of the slide operation apparatus taken along the line A-A in Fig. 1B.
{Fig. 2} Fig. 2 is a block diagram of an electrostatic sensor.

### {Description of Embodiments}

The following describes an embodiment of the invention with reference to the drawings. Figs. 1A, 1B, and 1C are diagrams illustrating a slide operation apparatus according to an embodiment of the invention. Fig. 1A is a top view, Fig. 1B is a side view in which a part of housing is omitted, and Fig. 1C is a cross-sectional view taken along the line A-A.

The slide operation apparatus is used as a fader that is, for example, used in a manner of multiple faders arranged in an acoustic mixer. The slide operation apparatus includes, in appearance, a first lower housing 11, a second lower housing 12, and an upper housing 13.

The first lower housing 11 and the second lower housing 12 are constituted of thin metal plates, and are coupled to each other so as to constitute a hollow housing in a rectangular parallelepiped shape. The first lower housing 11 forms a first side surface (a side surface at the X direction side in the drawings), a part of an inferior surface (at the -Z direction side in the drawings), and a part of a top surface (at the Z direction side in the drawings) of the slide operation apparatus. The second lower housing 12 forms a second side surface (a side surface at the -X direction side in the drawing), a part of the inferior surface, and a part of the top surface of the slide operation apparatus. Although not illustrated in the drawings, the first lower housing 11 and the second lower housing 12 also form a front surface (at the Y direction side) and a back surface (at the -Y direction side).

Inside the first lower housing 11 and the second lower housing 12, a slide shaft 17 and a moving body 22 are disposed. The slide shaft 17 extends in the longitudinal direction (the Y and -Y directions) of these housings. The moving body 22 is slidably supported by the slide shaft 17 and can be moved in the longitudinal direction of the slide shaft 17. The slide shaft 17 is a metal bar in a columnar shape and has both end portions secured to the respective first lower housing 11 and second lower housing 12.

The respective top surfaces of the first lower housing 11 and the second lower housing 12 are coupled to an upper housing 13. The upper housing 13 includes a horizontal portion and a standing portion. The horizontal portion is coupled to the first lower housing 11 and the second lower housing 12. The standing portion is disposed upright from both sides of the horizontal portion to the top side.

In the horizontal portion of the upper housing 13, a slit 71 extending in the longitudinal direction is formed. On the inferior surface side of the slit 71, a void between the first lower housing 11 and the second lower housing 12 is arranged. From this slit 71, a thin sheet-shaped control 21 is exposed. The control 21 extends from the moving body 22 to the top side.

As illustrated in Fig. 1C, the moving body 22 includes a slide housing 23 in a rectangular parallelepiped shape, a cylindrical member 171, and a guide shaft 24. The slide housing 23 is coupled with the operator 21. The cylindrical member 171 is coupled with the operator 21 and allows insertion of the slide shaft 17. The guide shaft 24 is coupled to the slide housing 23 and extends in the X direction from a surface on a side opposite to another surface coupled with the slide housing 23. That is, the respective configurations (the operator 21, the slide housing 23, the cylindrical member 171, and the guide shaft 24) illustrated in the shaded area of Fig. 1C are all integrally coupled together.

In the horizontal portion of the upper housing 13, a receiving pulley 15 and a drive pulley 16 are mounted on the end portions in the longitudinal direction. On the receiving pulley 15 and the drive pulley 16, a timing belt 91 is mounted. On the drive pulley 16, a motor 51 is mounted. The timing belt 91 is coupled with the control 21. Accordingly, when the timing belt 91 moves in association with the rotation of the motor 51, the control 21 moves in the longitudinal direction. Accordingly, the cylindrical member 171 of the moving body 22, which is coupled with the operator 21, slides on the slide shaft 17 and the moving body 22 slides to move.

The slide housing 23 includes a groove on the inferior surface side. A guide plate 121, which is an end portion of the second lower housing 12, is inserted into the groove such that the moving body 22 is held slidably in the longitudinal direction.

The moving body 22 can be not only moved by the motor 51, but also slid by manual operation on the control 21 by a user.

This slide operation apparatus detects slide position of the moving body 22 and outputs information indicative of the detected slide position to a control unit (not illustrated) of an acoustic mixer. Subsequently, the control unit of the acoustic mixer sets parameters such as a sound volume, a sound quality, and an effect according to the information.

The following describes a configuration of the slide-position detection of the moving body 22. As illustrated in Fig. 1B and Fig. 1C, the guide shaft 24 extending from the slide housing 23 in the X direction is in contact with the magnet 25 through a hole disposed in the magnet case 31. Here, the number of the guide shafts 24 is not limited to the example (three) in the embodiment.

The guide shaft 24 corresponds to a contact portion, and is not coupled with the magnet case 31 and the magnet 25. That is, the moving body 22 is not integrated with the magnet case 31 and the magnet 25, thus forming a separate component. Accordingly, the moving body 22 transmits a moving force, which is transmitted to the operator 21, to the magnet case 31 and the magnet 25 while the moving body 22 can move in a direction other than the longitudinal direction (the X and -X directions) to some extent.

The magnet 25 is a ferrite magnet in a rectangular parallelepiped shape. The magnet case 31 is coupled with the magnet 25. The magnet case 31 has a shape that opens to the X direction and covers the magnet 25. X direction side end portions of the magnet case 31 extend to the Z direction and the -Z direction, and the magnet case 31 is coupled with the -X direction side surface of the movable electrode 26.

As illustrated also in Fig. 2, the movable electrode 26 is a rectangular plane electrode formed on a printed circuit board and is covered with an insulator. A sliding member (sheet) 261 is attached to an X direction side surface of the insulator, among surfaces of the insulator. The sliding member 261 is made of a material (for example, foamed high-molecular polyethylene) with a low friction coefficient and high durability.

The sliding member 261 is in contact with a fixed electrode 30. The fixed electrode 30 is constituted of plane electrodes (a first induction electrode 32A, a second induction electrode 32B, a potential detecting electrode 33A, and a potential detecting electrode 33B) formed on a printed circuit board, and is covered with an insulator. The printed circuit board is coupled with the first lower housing 11. The first lower housing 11 is formed of a magnetic material such as a galvanized steel sheet. Here, the second lower housing 12 and the upper housing 13 employ a member (such as SUS) that is lightweight and has high strength.

Accordingly, the movable electrode 26 is crimped to the fixed electrode 30 due to attraction of the above-described magnet 25 to the first lower housing 11 by a magnetic force. The intensity of the magnetic field of the magnet 25 is adjusted so as to crimp the movable electrode 26 and the fixed electrode 30 together while allowing the movable electrode 26 to slide with a small operating force. Accordingly, the movable electrode 26 can slide in the longitudinal direction while facing the fixed electrode 30 at a certain distance via the sliding member 261 attached to the surface of the insulator.

Here, the sliding member 261 may be attached to the surface of the movable electrode 26.

The first lower housing 11 may be substituted by a magnet and the magnet 25 may be substituted by a magnetic material. This embodiment has a structure where the magnet is arranged inside the housing, thus preventing leakage of magnetic flux to the outside of the housing to reduce the influence on other components.

Next, Fig. 2 is a block diagram of an electrostatic sensor. The electrostatic sensor includes the above-described fixed electrode 30, the movable electrode 26 facing the fixed electrode 30, a power feeding unit 102, an analyzing unit 103, a motor driving unit 104, and a control unit 101. The power feeding unit 102 feeds power to the fixed electrode 30. The analyzing unit 103 detects capacitance between the fixed electrode 30 and the movable electrode 26 so as to detect position of the movable electrode 26.

The control unit 101 is a functional unit that integrally controls the respective configurations. The control unit 101 controls the motor driving unit 104 to drive the motor 51 and moves the timing belt 91 so as to move the movable electrode 26.

The fixed electrode 30 is constituted of the first induction electrode 32A, the second induction electrode 32B, the potential detecting electrode 33A, and the potential detecting electrode 33B. The first induction electrode 32A and the second induction electrode 32B are respectively a plane electrode that is long in the longitudinal direction of the slide operation apparatus and formed in a rectangular shape. The potential detecting electrode 33A and the potential detecting electrode 33B are arranged in a region between the first induction electrode 32A and the second induction electrode 32B.

The potential detecting electrode 33A and the potential detecting electrode 33B are plane electrodes in which electrode patterns change along the longitudinal direction of the slide operation apparatus (the electrode patterns are respectively in right triangle shapes in this example), and are arranged close to each other in a point-symmetrical relationship. Lengths of the potential detecting electrode 33A and the potential detecting electrode 33B in the longitudinal direction are the same as lengths of the first induction electrode 32A and the second induction electrode 32B in the longitudinal direction.

The first induction electrode 32A and the second induction electrode 32B are respectively coupled to the power feeding unit 102. The potential detecting electrode 33A and the potential detecting electrode 33B are respectively coupled to the analyzing unit 103.

The power feeding unit 102 outputs, for example, a transmission signal (a rectangular wave) in which a voltage changes in pulse shape in accordance with control of the control unit 101, so as to apply voltage to the induction electrode 32A and the induction electrode 32B.

When the voltage from the power feeding unit 102 is applied to the induction electrode 32A and the induction electrode 32B, electric charges are induced in the movable electrode 26 by an effect of electrostatic induction.

When the electric charges are induced in the movable electrode 26, electric charges are further induced in the potential detecting electrode 33A and the potential detecting electrode 33B by an effect of electrostatic induction.

Amounts of electric charges induced in the potential detecting electrode 33A and the potential detecting electrode 33B depend on the area of respective portions facing the movable electrode 26. Accordingly, for example, the amount of electric charges induced in the potential detecting electrode 33B becomes larger as the movable electrode 26 becomes closer to the motor 51 side. The amount of electric charges induced in the potential detecting electrode 33A becomes larger as the movable electrode 26 becomes farer from the motor 51.

The analyzing unit 103 obtains a difference value of amounts of the current based on the amount of electric charges induced in the potential detecting electrode 33A and the potential detecting electrode 33B, so as to detect the present position (the absolute position) of the movable electrode 26. Information on the detected position is outputted to the control unit 101 and then outputted from the control unit 101 to a control unit (not illustrated) of the acoustic mixer.

As described above, the electrostatic sensor can detect slide position of the movable electrode 26, that is, slide position of the moving body 22. Subsequently, in the electrostatic sensor, the fixed electrode 30 and the movable electrode 26 are crimped together by the magnetic force. Thus, a uniform pressure is applied in a wide area. This allows the movable electrode 26 to slide while ensuring a constant interelectrode distance without using a precision mechanical component or a component in a complex shape.

While in this embodiment the example where two of the potential detecting electrode 33A and the potential detecting electrode 33B in the triangular shapes are arranged has been described, the arrangement pattern of the potential detecting electrode is not limited to this example.

The invention can be used for an instrument that detects a position of a moving body to operate, for example, an operating unit of an electronic musical instrument and a movable portion of a general measuring instrument other than faders of the acoustic mixer described in the above embodiment.

### {Reference Signs List}

11... first lower housing, 12... second lower housing, 13... upper housing, 15... receiving pulley, 16... drive pulley, 17... slide shaft, 21... control, 22... moving body, 23... slide housing, 24... guide shaft, 25... magnet, 26... movable electrode, 30... fixed electrode, 31... magnet case, 51... motor, 71... slit, 91... timing belt

## Claims

1. An electrostatic sensor, comprising:
a fixed electrode (30) arranged along a predetermined direction;
a movable electrode (26) that faces the fixed electrode (30);
an analyzing unit (103) configured to detect a position of the movable electrode (26) based on capacitance between the movable electrode (26) and the fixed electrode (30);
a sliding member (261) disposed between the fixed electrode (30) and the movable electrode (26); and
a crimping member (25, 11) that crimps the fixed electrode (30) and the movable electrode (26) together by a magnetic force.

2. The electrostatic sensor according to claim 1,
wherein the crimping member (25, 11) includes a housing (11) made of magnetic material and a magnet (25) arranged inside the housing (11), and
the housing (11) and the magnet (25) form a structure that the housing (11) and the magnet (25) sandwiches the fixed electrode (30) and the movable electrode (26).

3. The electrostatic sensor according to claim 1 or 2,
wherein the sliding member is made of high-molecular polyethylene.

4. A slide operation apparatus, comprising:
the electrostatic sensor according to any one of claims 1 to 3; and
a moving body (22) configured to move in a predetermined direction,
wherein the moving body (22) comprises a contact portion (24) in contact with a part of the crimping member (25), and
the contact portion (24) is configured to transmit a moving force transmitted to the moving body (22) to the crimping member (25) such that the movable electrode (26) moves in the predetermined direction in association with movement of the moving body (22).
